# EUROPÄISCHE PATENTSCHRIFT

(11) **EP 2 408 112 B1**
(45) Veröffentlichungstag und Bekanntmachung des Hinweises auf die Patenterteilung: **11.11.2015**
(21) Anmeldenummer: 11004430.2
(22) Anmeldetag: 31.05.2011
(51) Int. Cl.: H03K 17/975

(54) **Kontaktmittel und Bedieneinrichtung für ein Haushaltsgerät**
Contact and operating device for a domestic appliance
Moyen de contact et dispositif de commande pour un appareil ménager

(30) Priorität: 15.07.2010 DE 102010027230
(43) Veröffentlichungstag der Anmeldung: 18.01.2012
(73) Patentinhaber: Siebe Appliance Controls GmbH, 78559 Gosheim (DE)
(72) Erfinder: Weinmann, Bernhard, 78559 Gosheim (DE)
(74) Vertreter: Patentanwälte Magenbauer & Kollegen Partnerschaft mbB

(56) Entgegenhaltungen:
- WO-A1-2006/034993
- DE-A1-102009 004 625
- DE-U1-202005 002 157
- US-A- 4 584 444

## Beschreibung

Die Erfindung betrifft ein Kontaktmittel aus einem langgestreckten federelastischen Material zur Kopplung eines Bedienfelds aus elektrisch isolierendem Material mit einer Sensoreinrichtung, das einen Montageabschnitt zur Montage auf einer gedruckten Schaltung, einen Federabschnitt zur Bereitstellung einer Anpreßkraft und einen Anlageabschnitt zur Anlage an dem Bedienfeld aufweist, wobei sich der Federabschnitt an den Montageabschnitt und der Anlageabschnitt an den Federabschnitt anschließen und der Federabschnitt wenigstens eine Federwindung. Ferner betrifft die Erfindung eine Bedieneinrichtung für ein Haushaltsgerät mit einem elektrisch isolierenden Bedienfeld und einer Sensoreinrichtung zur kapazitiven Abtastung des Bedienfelds, wobei der Anlageabschnitt als Spiralfeder ausgebildet ist und sich ein Windungsradius der Spiralfeder längs der Erstreckung der Spiralfeder mit zunehmendem Abstand vom Federabschnitt reduziert.

Aus der DE 102009004625 A1 ist eine Steuerungsvorrichtung bekannt, die eine Tragkonstruktion mit einer Grundplatte, ein mit der Grundplatte verbundenes Tastfeld und mindestens ein elektrisch leitendes Federelement umfasst, wobei das Federelement in zusammengedrücktem Zustand zwischen der Grundplatte und dem Tastfeld eingefügt ist und einen Endbereich enthält, der infolge der Pressung gegen das Feld abgeflacht ist. Das elektrisch leitende Federelement enthält einen in Querrichtung vorspringenden mittleren Bereich und die Tragkonstruktion enthält überdies mindestens ein Rückhalte- und Führungselement, das zwischen der Grundplatte und dem Feld angeordnet ist und einen Durchlass mit einem Anschlag ausbildet. Das elektrisch leitende Federelement ist in der Weise in dem Durchlass des Rückhalte- und Führungselements angeordnet, dass sein vorspringender Bereich an dem Anschlag anstößt.

Aus der WO2006034993 ist ein kapazitiver berührungsempfindlicher Schalter mit einem elektrisch leitenden Körper bekannt, wobei der Körper zwischen einer elektrisch isolierenden Abdeckplatte und einer Trägerplatte angeordnet ist und bei dem die Abdeckplatte elastisch verformt werden kann. Der elektrisch leitende Körper liegt an der unteren Seite der Abdeckplatte mit seinem oberen, als Sensorfläche ausgebildeten Ende an. Ferner liegt der Körper an seinem unteren Ende mit einem elektrisch leitenden Kontakt an der Trägerplatte an und ist als Druckfeder ausgebildet.

Aus der DE 20 2005 002 157 U1 ist eine kapazitive Sensorvorrichtung zu Abtastung eines kapazitiv gekoppelten Berührfelds bekannt. Das Berührfeld weist eine Oberseite und eine Unterseite auf. An der Unterseite des Berührfelds ist eine Haltevorrichtung angebracht. Ein aus einer Feder gebildetes Sensorelement erstreckt sich von der Haltevorrichtung zur Unterseite des Berührungsfeldes. Dabei weist die Feder einen erweiterten Teil auf, welcher bei Kompression abgeflacht wird, um einen erweiterten Kontaktbereich auf der Unterseite des Berührungsfelds auszubilden.

Die Aufgabe der Erfindung besteht darin, ein Kontaktmittel bereitzustellen, das bei besonders kompakter Gestaltung eine vorteilhafte Kopplung zwischen Bedienfeld und Sensoreinrichtung ermöglicht.

Diese Aufgabe wird für ein Kontaktmittel der eingangs genannten Art mit den Merkmalen des Anspruchs 1 gelöst. Hierbei ist vorgesehen, dass in einer Tangentialebene an den Federabschnitt ein Verbindungsbereich ausgebildet ist, der in der Tangentialebene einen V-förmigen Verlauf aufweist und der den Federabschnitt und den Endbereich des Montageabschnitts miteinander verbindet.

Der dem Montageabschnitt zugehörige Verbindungsbereich dient dazu, eine Beabstandung des Federabschnitts von der gedruckten Schaltung zu gewährleisten. Somit können in einem Flächenbereich unterhalb des Kontaktmittels, der der Projektionsfläche des Kontaktmittels auf die gedruckte Schaltung entspricht, isolierte oder nicht isolierte Leiterbahnen der gedruckten Schaltung verlaufen können, ohne dass bei einer Kompression des Kontaktmittels ein unerwünschter elektrischer Kontakt zwischen benachbarten Leiterbahnen durch das Kontaktmittel hergestellt wird.

Dabei kann ein erster Schenkel des Verbindungsbereichs für einen tangentialen Übergang in den Federabschnitt ausgebildet sein. Ein zweiter Schenkel des Verbindungsbereichs kann im Wesentlichen senkrecht zur Mittelachse der Spiralfeder und/oder zur Mittelachse des Federabschnitts ausgerichtet sein und als Abstützung des Kontaktmittels auf der gedruckten Schaltung dienen. Hierdurch wird in einem weiten Deformationsbereich für das Kontaktmittel sichergestellt, dass dieses lediglich mit dem zweiten Schenkel des Verbindungsbereichs linienartig auf der Oberfläche der gedruckten Schaltung aufliegt, während die übrige Projektionsfläche des Kontaktmittels auf der gedruckten Schaltung bei bestimmungsgemäßem Einsatz des Kontaktmittels freibleibt.

Der Anlageabschnitt des Kontaktmittels ist hierbei derart ausgebildet, dass sich der als Spiralfeder ausgebildete Anlageabschnitt mit zunehmendem Abstand von dem Federabschnitt verjüngt, wodurch eine besonders kompakte Gestaltung des Kontaktmittels erreicht wird. Vorzugsweise ist der geringste Windungsradius der Spiralfeder derart gewählt, dass ein auf der Sensoreinrichtung unterhalb des Kontaktmittels angeordnetes Leuchtmittel, beispielsweise eine Leuchtdiode, insbesondere eine SMD-Leuchtdiode (oberflächen-montierbare Leuchtdiode), den freien Innendurchmesser der Spiralfeder durchstrahlen kann und somit als optische Anzeige für eine Funktionalität auch durch das vorzugsweise aus optisch transparentem Material hergestellten Bedienfeld von einem Benutzer wahrgenommen werden kann. Durch die Ausbildung des Anlageabschnitts als Spiralfeder wird gewährleistet, dass mehrere Windungen des Anlageabschnitts flächig an dem Bedienfeld anliegen, um eine besonders vorteilhafte kapazitive Kopplung zwischen dem Bedienfeld und der Sensoreinrichtung zu gewährleisten. Dies gilt insbesondere dann, wenn die Reduktion des Windungsradius der Spiralfeder längs der Erstreckung der Spiralfeder mit zunehmendem Abstand vom Federabschnitt derart gewählt ist, dass ein Anliegen sämtlicher Windungen der Spiralfeder an dem Bedienfeld gewährleistet ist.

Vorteilhafte Weiterbildungen der Erfindung sind Gegenstand von Unteransprüchen.

Zweckmäßig ist es, wenn die Änderung des Windungsradius der Spiralfeder innerhalb einer Spiralfederwindung zumindest gleich, insbesondere größer, als der Querschnitt, insbesondere als der Durchmesser, des langgestreckten, federelastischen Materials ist. Hierdurch wird sichergestellt, dass für die Spiralfeder in einer Planlage, bei der die Windungen der Spiralfeder an einer ebenen Oberfläche zur Anlage gebracht werden sollen, keine Überschneidung benachbarter Spiralfederwindungen auftritt. Hierzu muss der Gradient der Änderung des Windungsradius derart gewählt sein, dass sich ein Radius der Windung zwischen einer vorhergehenden und einer nachfolgenden Windung zumindest um den Querschnitt des langgestreckten Materials unterscheidet. Bevorzugt ist vorgesehen, dass die Änderung des Windungsradius innerhalb einer Windung größer als der Querschnitt des langgestreckten federelastischen Materials gewählt ist, um eine möglichst reibungsarme Anlage benachbarter Windungen in der Planlage des Anlageabschnitts zu gewährleisten.

Bei einer Weiterbildung der Erfindung ist vorgesehen, dass eine Steigung der Federwindung des Federabschnitts um wenigstens 50%, vorzugsweise wenigstens um 100%, größer als eine Steigung der Federwindung der Spiralfeder gewählt ist. Hierdurch wird gewährleistet, dass bei einer Kompression des Kontaktmittels, wie sie bei einer Montage des Kontaktmittels zwischen die Sensoreinrichtung und dem Bedienfeld auftritt, die hierbei in das Kontaktmittel eingeleitete Deformationsenergie zu einer zumindest nahezu vollständigen Abflachung des Anlageabschnitts führt, während aufgrund der größeren Steigung des Federabschnitts nur eine teilweise Abflachung des Federabschnitts eintritt. Hierdurch ist die gewünschte Kopplung zwischen dem Bedienfeld und der Sensoreinrichtung mit Hilfe des Kontaktmittels zum einen durch die flächige Anlage der Anlageabschnitts am Bedienfeld und zum anderen durch die Federwirkung des Federabschnitts sichergestellt. Der Unterschied in der Steigung des Federabschnitts gegenüber der Steigung des Anlageabschnitts gleicht die aufgrund der Verjüngung des Anlageabschnitts mit zunehmendem Abstand vom Federabschnitt auftretende Versteifung des Anlageabschnitts aus. Dadurch wird die gewünschte flächige Anlage des Anlageabschnitts am Bedienfeld gewährleistet.

Vorteilhaft ist es, wenn eine Mittelachse der Spiralfeder zumindest im Wesentlichen parallel zu einer Mittelachse des Federabschnitts ausgerichtet, vorzugsweise identisch mit der Mittelachse der Federwindung, ist. Hierdurch ist sichergestellt, dass die Spiralfeder allenfalls exzentrisch zur Federwindung des Federabschnitts ausgerichtet ist, vorzugsweise jedoch konzentrisch zum Federabschnitt angeordnet ist. Dies stellt eine verkippungsfreie und damit vorteilhafte Anlage des Anlageabschnitts an dem Bedienfeld sicher.

Bei einer vorteilhaften Weiterbildung der Erfindung ist vorgesehen, dass der Montageabschnitt einen zumindest im Wesentlichen parallel zur Mittelachse der Spiralfeder und/oder der Mittelachse des Federabschnitts ausgerichteten Endbereich aufweist, der für ein Einstecken in eine Ausnehmung in einer gedruckten Schaltung ausgebildet ist. Eine Grundfunktion des Montageabschnitts besteht darin, eine Festlegung des Kontaktmittels an einer gedruckten Schaltung, auf der beispielsweise auch die Sensoreinrichtung ausgebildet ist, zu gewährleisten. Hierzu weist der Montageabschnitt einen, vorzugsweise geradlinig, ausgebildeten Endbereich auf, der in eine Sacklochbohrung oder Durchgangsbohrung in der gedruckten Schaltung aufgenommen werden kann. Besonders bevorzugt ist der Endbereich des Montageabschnitts derart bemessen, dass er größer als die Dicke der gedruckten Schaltung ist, um eine Verlötung des Endbereichs auf einer dem Kontaktmittel abgewandten Seite der gedruckten Schaltung zu ermöglichen.

Zweckmäßig ist es, wenn der Federabschnitt als zylindrische Wendelfeder ausgebildet ist. Hierdurch wird einerseits eine kompakte Gestaltung des Kontaktmittels ermöglicht, andererseits ist hierdurch eine besonders ökonomische Herstellung des Kontaktmittels möglich.

Bei einer vorteilhaften Weiterbildung der Erfindung ist vorgesehen, dass zwischen dem Federabschnitt und dem Montageabschnitt ein Verbindungsbereich angeordnet ist, der derart ausgebildet ist, dass bei Anordnung des Kontaktmittels zwischen dem Bedienfeld und der gedruckten Schaltung eine Berührung der gedruckten Schaltung durch den Federabschnitt vermieden wird. Der Verbindungsbereich ist derart ausgestaltet, dass er bei bestimmungsgemäßem Gebrauch des Kontaktmittels, also bei Einhaltung eines vorgebbaren Minimal- und Maximalabstands zwischen Bedienfeld und der gedruckten Schaltung der Sensoreinrichtung, an der das Kontaktmittel angebracht ist, eine zuverlässige Beabstandung des Federabschnitts von der gedruckten Schaltung gewährleistet. Hierdurch ist es möglich, unterhalb des Kontaktmittels auf der Oberfläche der gedruckten Schaltung elektrische Leiterbahnen und/oder elektrische oder andere Komponenten anzuordnen. Beispielsweise kann vorgesehen sein, unterhalb des Kontaktmittels eine oder mehrere Leuchtdioden und die zugehörigen elektrischen Leiterbahnen anzuordnen, wobei die Leuchtdioden für eine Funktionsanzeige der Sensoreinrichtung dienen können und durch das Bedienfeld und das Kontaktmittel hindurch sichtbar angeordnet werden können. Durch den Verlauf von elektrischen Leiterbahnen auf der Oberfläche der gedruckten Schaltung kann ein vereinfachtter Aufbau der gedruckten Schaltung erzielt werden, da ein Kurzschluss von Leiterbahnen, die unterhalb des Kontaktmittels auf der gedruckten Schaltung verlaufen, aufgrund der Funktion des Verbindungsbereichs vermieden werden.

Bei einer Weiterbildung der Erfindung ist vorgesehen, dass der Verbindungsbereich in einem Randbereich einer Projektionsfläche des Federabschnitts und des Anlageabschnitts auf der gedruckten Schaltung anliegt. Hierdurch wird eine vorteilhafte Ausnutzung der Oberfläche der gedruckten Schaltung, insbesondere im Bereich unterhalb des Kontaktmittels, der auch als Projektionsfläche bezeichnet wird, gewährleistet.

In weiterer Ausgestaltung der Erfindung ist vorgesehen, dass der Verbindungsbereich in einander gegenüberliegenden Randbereichen einer Projektionsfläche des Federabschnitts und des Anlageabschnitts auf die gedruckte Schaltung auf einer Oberfläche der gedruckten Schaltung anliegt. Durch eine beidseitige Anlage des Verbindungsbereichs an der Oberfläche der gedruckten Schaltung kann eine besonders vorteilhafte Stabilisierungswirkung des Verbindungsbereichs für das Kontaktmittel erreicht werden, ohne dass hierfür erhebliche Einschränkungen bei der Ausnutzung der zur Verfügung stehenden Oberfläche der gedruckten Schaltung in Kauf genommen werden müssen.

Vorzugsweise ist der Verbindungsbereich für eine linienförmige und/oder für eine punktförmige Anlage auf der Oberfläche der gedruckten Schaltung ausgebildet ist. Eine linienförmige Anlage kann geradlinig oder gekrümmt vorgesehen sein. Vorzugsweise ist der Verbindungsbereich so gestaltet, dass auf einer ersten Seite eine linienförmige Anlage und auf einer zweiten Seite, die der ersten Seite gegenüberliegt, eine punktförmige Anlage vorliegt.

Die Aufgabe der Erfindung wird für eine Bedieneinrichtung für ein Haushaltsgerät mit den Merkmalen des Anspruchs 9 gelöst.

Hierbei ist vorgesehen, dass die Bedieneinrichtung ein elektrisch isolierendes Bedienfeld und eine Sensoreinrichtung zur kapazitiven Abtastung des Bedienfelds umfasst, wobei ein erfinderungsgemäßes Kontaktmittel zur Bereitstellung einer elektrisch leitenden Verbindung zwischen der Sensoreinrichtung und dem Bedienfeld eingerichtet ist. Das Kontaktmittel erlaubt somit eine Montage der Sensoreinrichtung gegenüber dem Bedienfeld mit großen mechanischen Toleranzen, wie sie für die industrielle Produktion, insbesondere von Haushaltsgeräten, von Vorteil sind. Hierbei ist zu beachten, dass das Bedienfeld typischerweise als mechanischer Bestandteil des Haushaltsgerätes zunächst unabhängig von der Sensoreinrichtung montiert wird und in einem nachgelagerten Arbeitsschritt die Sensoreinrichtung in das Haushaltsgerät montiert wird und elektrisch angeschlossen wird. Um diesen Montageschritt besonders einfach halten zu können, ist es vorteilhaft, wenn die Lage der Sensoreinrichtung gegenüber dem Bedienfeld mit großer mechanischer Toleranz versehen werden kann. Dem Kontaktmittel, dass vorzugsweise aus einem federelastischen Metalldraht, der gegebenenfalls mit einer elektrisch leitenden Korrosionsschutzbeschichtung versehen ist, kommt die Aufgabe zu, einen elektrischen Kontakt zwischen Sensoreinrichtung und dem elektrisch isolierenden Bedienfeld herzustellen, um eine kapazitive Abtastung des Bedienfelds zu ermöglichen. Insbesondere bei Bedienfeldern mit einer hohen Integration von unterschiedlichen Bedienfunktionen, die dicht nebeneinander angeordnete, voneinander unterschiedliche Tastbereiche umfassen, ist die kompakte Gestaltung des erfindungsgemäßen Kontaktmittels von Vorteil, um eine sichere Ortsauflösung der jeweiligen Bedienfunktion für die Bedieneinrichtung gewährleisten zu können.

Bei einer Weiterbildung der Erfindung ist vorgesehen, dass das Bedienfeld eine der Sensoreinrichtung gegenüberliegende, zumindest im Wesentlichen ebene Anlagefläche für das Kontaktmittel aufweist und dass das Bedienfeld derart von der Sensoreinrichtung beabstandet angeordnet ist, dass das Kontaktmittel zumindest im Wesentlichen mit dem Anlageabschnitt flächig an der Anlagefläche anliegt. Durch die ebene Anlagefläche am Bedienfeld wird eine vorteilhafte kapazitive Kopplung zwischen Sensoreinrichtung, Kontaktmittel und Bedienfeld unterstützt. Dies ist insbesondere dann der Fall, wenn das Kontaktmittel aufgrund der Beabstandung von Sensoreinrichtung und Bedienfeld derart komprimiert wird, dass zumindest nahezu alle Windungen des als Spiralfeder ausgebildeten Anlageabschnitts flächig an der Anlagefläche anliegen.

In weiterer Ausgestaltung der Erfindung ist vorgesehen, dass die Sensoreinrichtung eine gedruckte Schaltung umfasst, an der das Kontaktmittel angeordnet ist und dass auf einer Oberfläche der gedruckten Schaltung elektrische Leiterbahnen ausgebildet sind, die zumindest abschnittsweise über eine Projektionsfläche des Federabschnitts und des Anlageabschnitts verlaufen und/oder elektrische Komponenten angeordnet sind. Hierbei wird die vorteilhafte Aufbauweise des erfindungsgemäßen Kontaktmittels ausgenutzt, das derart aufgebaut ist, dass es bei bestimmungsgemäßem Gebrauch nicht mit seinem Federabschnitt an der Oberfläche der gedruckten Schaltung anliegt. Somit können unterhalb des Kontaktmittels elektrische Leiterbahnen geführt und gegebenenfalls elektrische oder elektronische Komponenten angeordnet werden. Hierdurch wird einerseits ein vereinfachter Aufbau der gedruckten Schaltung ermöglicht, da beispielsweise elektrische Leiterbahnen zur Versorgung von Leuchtdioden, die unterhalb des Kontaktmittels zur Anzeige der Funktion der dem Kontaktmittel zugeordneten Sensorfunktion vorgesehen sind, auf der Oberfläche der gedruckten Schaltung geführt werden können. Andererseits wird eine kompaktere Auslegung der gedruckten Schaltung ermöglicht.

Vorteilhafte Ausführungsformen der Erfindung sind in der Zeichnung dargestellt. Dabei zeigt:
Figur 1 eine Draufsicht auf eine Sensoreinrichtung mit mehreren daran angebrachten Kontaktmitteln,
Figur 2 eine Vorderansicht der Sensoreinrichtung mit den daran angebrachten Kontaktmitteln,
Figur 3 eine Seitenansicht der Sensoreinrichtung und des Kontaktmittels in einer Neutralposition,
Figur 4 eine Seitenansicht der Sensoreinrichtung mit den daran angebrachten Kontaktmitteln sowie einem Bedienfeld in einer Funktionsposition,
Figur 5 eine perspektivische Darstellung des Kontaktmittels, und
Figur 6 eine Seitenansicht einer zweiten Ausführungsform der Sensoreinrichtung mit einem gegenüber der ersten Ausführungsform modifizierten Kontaktmittel,
Figur 7 eine Vorderansicht der zweiten Ausführungsform der Sensoreinrichtung und
Figur 8 eine geschnittene Draufsicht auf die gedruckte Schaltung.

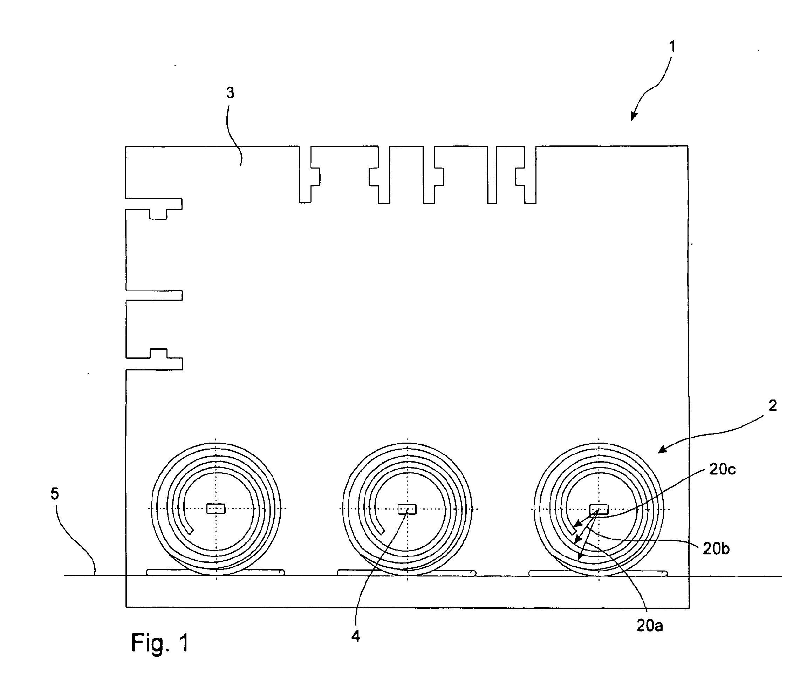

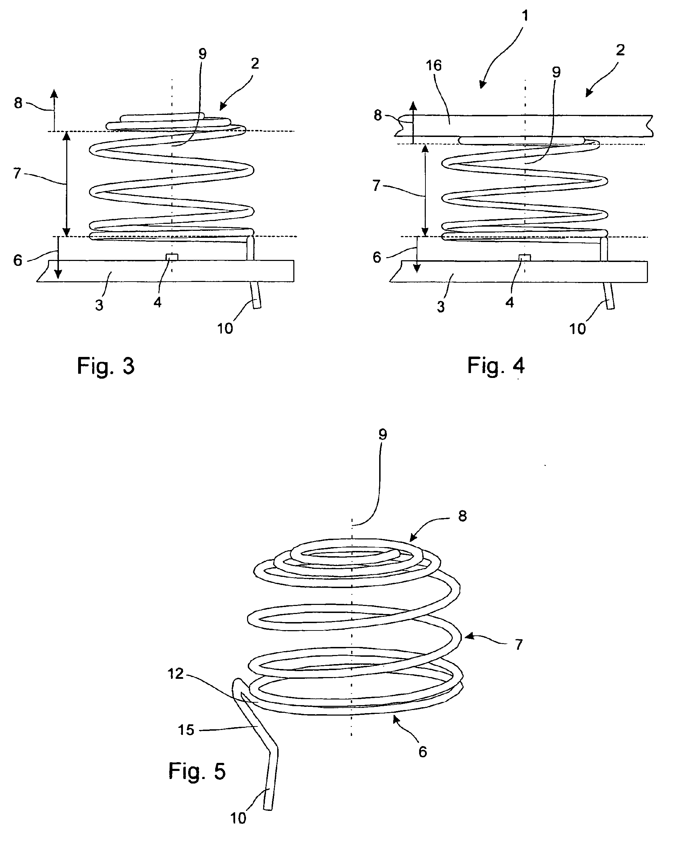

Eine in der Figur 1 dargestellte Sensoreinrichtung 1 ist mit mehreren, jeweils aus einem metallischen Draht hergestellten Kontaktmitteln 2 versehen. Die Sensoreinrichtung 1 umfasst eine gedruckte Schaltung 3 mit mehreren nicht näher dargestellten Leiterbahnen und nicht näher bezeichneten elektrischen Komponenten wie integrierte Schaltkreise, Widerstände, Kondensatoren, etc.. Die Kontaktmittel 2 sind mit der gedruckten Schaltung 3 sowohl elektrisch als auch mechanisch verbunden. Die von den elektrischen Komponenten und den Leiterbahnen gebildete elektrische Schaltung dient zur Abtastung eines in Figur 4 dargestellten Bedienfelds mittels kapazitiver Kopplung und somit zur Detektion von Benutzereingaben. Die Benutzereingaben werden durch Berühren einer Oberfläche des Bedienfelds durch einen Benutzer vorgenommen, wodurch eine lokale Kapazitätsänderung des Bedienfelds gegenüber der Sensoreinrichtung 1 eintritt. Diese Kapazitätsänderung kann durch die Sensoreinrichtung 1 detektiert werden. Die Kontaktmittel 2 dienen zur elektrischen Verbindung der Sensoreinrichtung 1 mit dem Bedienfeld, sie sind für eine flächige Anlage an dem vorzugsweise eben ausgebildeten Bedienfeld ausgebildet. Jedes der Kontaktmittel 2 weist eine Anzahl von nachstehend näher beschriebenen Federwindungen auf.

Ein Innendurchmesser des Kontaktmittels 2 ist derart gewählt, dass ein auf der gedruckten Schaltung 3 angebrachtes Leuchtmittel 4, bei dem es sich beispielsweise um eine Leuchtdiode handeln kann, störungsfrei durch den Innendurchmesser des Kontaktmittels 2 hindurch strahlen kann. Das Leuchtmittel 4 kann beispielsweise als Kontrollleuchte für Funktionen, die über das nicht dargestellte, kapazitiv bedienbare Bedienfeld abrufbar sind, dienen.

Aus der Figur 1 geht hervor, dass das Kontaktmittel 2 einen nachstehend näher beschriebenen Verbindungsbereich aufweist, der in einer senkrecht zur Darstellungsebene der 1 Figur verlaufenden und die Verbindungsachse 5 umfassenden Tangentialebene angeordnet ist.

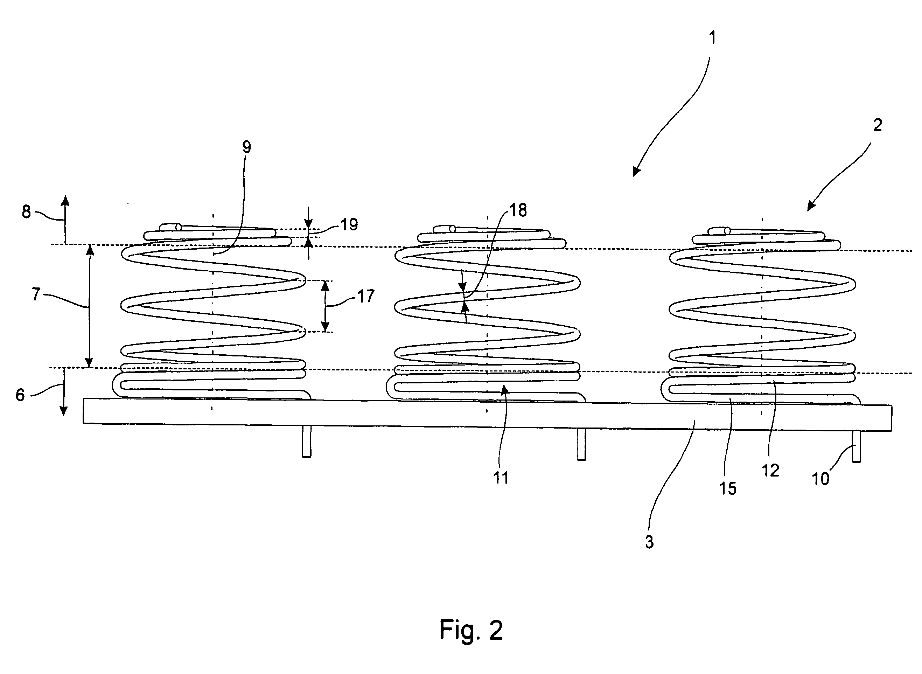

Aus der Figur 2 gehen die unterschiedlichen Funktionsbereiche des Kontaktmittels 2 hervor. Hier sind der im Eingriff mit der gedruckten Schaltung 3 stehende Montageabschnitt 6, der im Wesentlichen die Elastizität des Kontaktmittels 2 bestimmende Federabschnitt 7 sowie der zur Anlage an das nur in Figur 4 dargestellte Bedienfeld vorgesehene Anlageabschnitt 8 erkennbar.

Der Montageabschnitt 6 umfasst einen parallel zur Mittelachse 9 des Kontaktmittels 2 verlaufenden Endbereich 10, der exemplarisch als gerades Drahtstück ausgebildet ist und zur Durchsteckmontage in eine Durchgangsbohrung der gedruckten Schaltung 3 sowie zur Verlötung an der gedruckten Schaltung 3 vorgesehen ist. Vorzugsweise wird die Verlötung des Endbereichs 10 an derjenigen Oberfläche der gedruckten Schaltung 3 vorgenommen, die dem übrigen Kontaktmittel 2 entgegengesetzt ist.

An den Endbereich 10 schließt sich ein ebenfalls dem Montageabschnitt 6 zugehöriger, exemplarisch V-förmig ausgebildeter Verbindungsbereich 11 an, dessen erster Schenkel 12 für den tangentialen Übergang in den nachstehend näher beschriebenen Federabschnitt 7 vorgesehen ist. Der zweite Schenkel 15 des Verbindungsbereichs 11 ist mit dem Endbereich 10 einstückig verbunden und ist zur linienförmigen Auflage des Kontaktmittels 2 auf der gedruckten Schaltung 3 vorgesehen. Hierdurch können Kräfte auf das Kontaktmittel 2, die im Wesentlichen längs der Mittelachse 9 aufgebracht werden, in vorteilhafter Weise abgestützt werden.

Der Federabschnitt 7 des Kontaktmittels 2 ist exemplarisch als zylindrische Wendelfeder ausgeführt. Eine Steigung 17 des wendelförmig ausgebildeten Federabschnitts 7 beträgt ein Mehrfaches des Durchmessers 18 des langgestreckten, federelastischen Materials, aus dem das Kontaktmittel 2 in einstückiger Weise hergestellt ist. Exemplarisch beträgt die Steigung 17 der Wendelfeder ungefähr das 6-fache des Drahtdurchmessers 18 des Kontaktmittels 2. Besonders bevorzugt ist für den Übergangsbereich zwischen Federabschnitt 7 und Montageabschnitt 6 eine deutliche Reduzierung der Steigung der Wendelfeder vorgesehen, um ein Aufliegen der ersten Federwindung auf dem ersten Schenkel 12 des Verbindungsbereichs 11 und damit eine stabile Abstützung des Federabschnitts 7 auf dem Montageabschnitt 6 zu erzielen.

An den Federabschnitt 7 schließt sich der in Form einer Spiralfeder ausgebildete Anlageabschnitt 8 an. Die Steigung 19 der Spiralfeder im Anlageabschnitt 8 entspricht exemplarisch ungefähr dem Durchmesser 18 des langgestreckten, federelastischen Materials, aus dem das Kontaktmittel 2 hergestellt ist. Vorliegend ist die Steigung 19 der Spiralfeder identisch mit dem Durchmesser 18 des Drahts, aus dem das Kontaktmittel 2 einstückig gewickelt worden ist.

Wie aus der Figur 1 entnommen werden kann, ändert sich der Windungsradius 20a, 20b, 20c des als Spiralfeder ausgebildeten Anlageabschnitts 8 längs der Erstreckung der Spiralfeder mit zunehmendem Abstand vom Federabschnitt 7. Exemplarisch ist die Änderung des Windungsradius 20a, 20b, 20c derart gewählt, dass die Windungen des als Spiralfeder ausgebildeten Anlageabschnitts 8 im unkomprimierten Zustand des Kontaktmittels 2 jeweils um den Querschnitt des langgestreckten, federelastischen Materials voneinander beabstandet sind, aus dem das Kontaktmittel 2 hergestellt ist.

Durch die Auswahl der Steigung des Federabschnitts 7 und des Anlageabschnitts 8 sowie die Auswahl der Reduktion des Windungsradius der Spiralfeder lässt sich ein in der Figur 4 exemplarisch dargestelltes Einfederungsverhalten für das Kontaktmittel 2 erzielen. Hierdurch ist einerseits eine möglichst großflächige Anlage des Kontaktmittels 2 an dem exemplarisch plattenförmig ausgebildeten Bedienfeld 16 gewährleistet, andererseits soll das aufgrund der Kompression des Kontaktmittels 2 längs der Mittelachse 9 im Verbindungsbereich 11 auftretende Biegemoment auf den zweiten Schenkel 15 auf einem Niveau liegen, das eine unerwünschte Annäherung der ersten Windung des Federabschnitts 7 an die Oberfläche der gedruckten Schaltung 3 vermeidet. Hierdurch ist es möglich, um das in den Figuren 3 und 4 erkennbare Leuchtmittel 4 isolierte oder auch nicht isolierte elektrische Leiterbahnen auf der gedruckten Schaltung 3 auszubilden. Das Kontaktmittel 2 erfordert abseits der linienförmigen Auflage des zweiten Schenkels 15 auf der gedruckten Schaltung 3 keinen Platz und ermöglicht somit eine Ausnutzung der Fläche unterhalb des Kontaktmittels 2 und dadurch eine kompakte Gestaltung der gedruckten Schaltung 3.

Wie der Figur 1 entnommen werden kann, umfasst bei der dargestellten Ausführungsform des Kontaktmittels 2 der Anlageabschnitt 8 insgesamt zwei vollständige Windungen, wobei auch der direkt an den Anlageabschnitt 8 angrenzende Windungsteil des Federabschnitts 7 in Anlage an das Bedienfeld 16 kommen kann. Aufgrund der Verjüngung des Kontaktmittels 2 im Bereich des Anlageabschnitts 8 ist dieses besonders kompakt gestaltet und ermöglicht dennoch aufgrund der unterschiedlichen Steigungen des Federabschnitts 7 und des Anlageabschnitts 8 in einem groß gewählten Toleranzbereich eine großflächige Anlage des Kontaktmittels 2 am Bedienfeld 16, wodurch eine zuverlässige Abtastung des Bedienfelds 16 gewährleistet ist.

Für eine verbesserte Kompensation des am zweiten Schenkel 15 bei Kompression des Kontaktmittels 2 auftretenden Drehmoments kann vorgesehen sein, den Endbereich 10 nicht parallel zur Mittelachse 9, sondern in radialer Richtung schräg nach außen gestellt in einem spitzen Winkel zur Mittelachse 9 auszustellen, so dass in einem unbelasteten Ruhezustand das Kontaktmittel 2 mit seiner Mittelachse 9 schräg zur Flächennormalen auf die gedruckte Schaltung 3 ausgerichtet ist, jedoch im Einbauzustand aufgrund der auftretenden Kräfte und der dadurch bewirkten Verkippung des Anlageabschnitts 8 und des Federabschnitts 7 um den zweiten Schenkel 15 zu einer im Wesentlichen senkrechten Ausrichtung der Mittelachse 9 gegenüber der Flächennormalen der gedruckten Schaltung 3 zu führen.

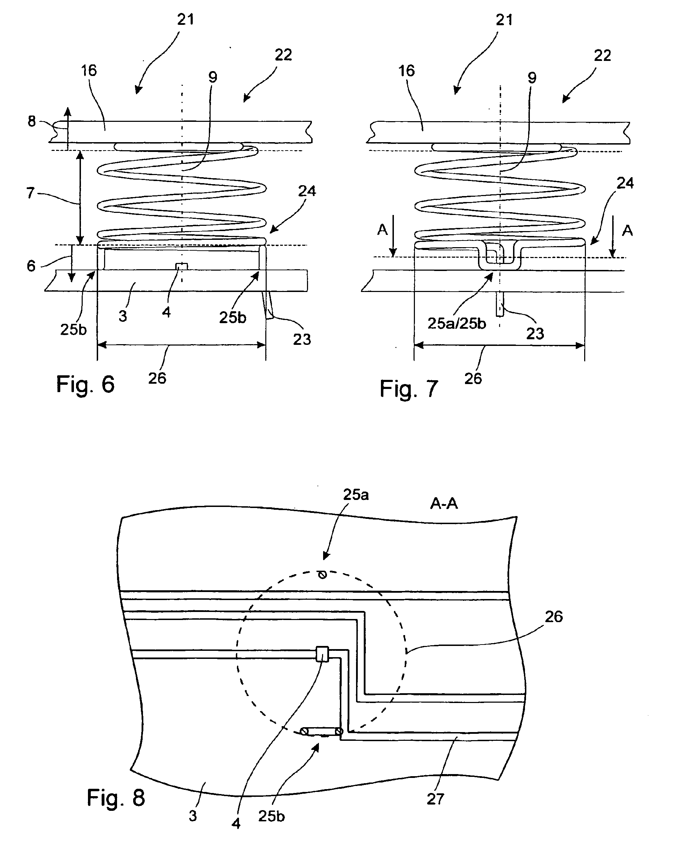

Bei der in den Figuren 6 bis 8 dargestellten zweiten Ausführungsform einer Sensoreinrichtung 21 ist ein modifiziertes Kontaktmittel 22 vorgesehen, dass sich vom Kontaktmittel 2 dadurch unterscheidet, dass der Verbindungsbereich 24 zwei Abstützbereiche 25, die zur Unterscheidung mit 25a, 25b bezeichnet werden, umfasst. Der erste Abstützbereich 25a grenzt unmittelbar an den Montageabschnitt 23, der zweite Abstützbereich 25b ist gegenüberliegend zum ersten Abstützbereich 25a ausgebildet und exemplarisch für eine linienförmige Auflage auf der Oberfläche der gedruckten Schaltung 3 ausgebildet. Durch die zwei Abstützbereiche 25a, 25b ist eine besonders stabile und sichere Abstützung des Kontaktmittels 22 an der gedruckten Schaltung 3 sichergestellt. Eine Projektionsfläche 26 des Kontaktmittels 22 auf die gedruckte Schaltung 3 ist insbesondere in der Schnittdarstellung der Figur 8 erkennbar. Aus der Figur 8 geht auch hervor, dass die erfindungsgemäße Gestaltung des Verbindungsbereichs 11, 24 eine Anordnung von Leiterbahnen 27 in der Projektionsfläche 26 ermöglicht, da ein mechanischer und elektrischer Kontakt des jeweiligen Federabschnitts 7 mit der Oberfläche der gedruckten Schaltung 3 durch die jeweiligen Verbindungsbereiche 11, 24 verhinder wird.

## Patentansprüche

1. Kontaktmittel aus einem langgestreckten federelastischen Material zur Kopplung eines Bedienfelds (16) aus elektrisch isolierendem Material mit einer Sensoreinrichtung (1; 21); das einen Montageabschnitt (6; 23) zur Montage auf einer gedruckten Schaltung (3), einen Federabschnitt (7) zur Bereitstellung einer Anpreßkraft und einen Anlageabschnitt (8) zur Anlage an dem Bedienfeld (16) aufweist, wobei sich der Federabschnitt (7) an den Montageabschnitt (6; 23) und der Anlageabschnitt (8) an den Federabschnitt (7) anschließen und der Federabschnitt (7) wenigstens eine Federwindung umfasst, wobei der Anlageabschnitt (8) als Spiralfeder ausgebildet ist und sich ein Windungsradius (20a, 20b, 20c) der Spiralfeder längs der Erstreckung der Spiralfeder mit zunehmendem Abstand vom Federabschnitt (7) reduziert, **dadurch gekennzeichnet, dass** in einer Tangentialebene an den Federabschnitt (7) ein Verbindungsbereich (11; 24) ausgebildet ist, der in der Tangentialebene einen V-förmigen Verlauf aufweist und der den Federabschnitt (7) und den Endbereich (10) des Montageabschnitts (6; 23) miteinander verbindet.

2. Kontaktmittel nach Anspruch 1, **dadurch gekennzeichnet, dass** die Änderung des Windungsradius der Spiralfeder innerhalb einer Spiralfederwindung zumindest gleich, insbesondere größer, als der Querschnitt, insbesondere als der Durchmesser, des langgestreckten federelastischen Materials ist.

3. Kontaktmittel nach Anspruch 1 oder 2, **dadurch gekennzeichnet, dass** eine Steigung (17) der Federwindung des Federabschnitts (7) wenigstens um 50%, vorzugsweise wenigstens um 100%, größer als eine Steigung (19) der Federwindung der Spiralfeder gewählt ist.

4. Kontaktmittel nach Anspruch 1, 2 oder 3, **dadurch gekennzeichnet, dass** eine Mittelachse (9) der Spiralfeder zumindest im Wesentlichen parallel zu einer Mittelachse des Federabschnitts (7) ausgerichtet, vorzugsweise identisch mit der Mittelachse der Federwindung, ist.

5. Kontaktmittel nach einem der vorhergehenden Ansprüche, **dadurch gekennzeichnet, dass** der zumindest im Wesentlichen parallel zur Mittelachse (9) der Spiralfeder und/oder der Mittelachse (9) des Federabschnitts ausgerichtete Endbereich (10) des Montageabschnitts (6) für ein Einstecken in eine Ausnehmung in einer gedruckten Schaltung (3), insbesondere der Sensoreinrichtung (1; 21), ausgebildet ist.

6. Kontaktmittel nach einem der vorhergehenden Ansprüche, **dadurch gekennzeichnet, dass** der Federabschnitt (7) als zylindrische Wendelfeder ausgebildet ist.

7. Kontaktmittel nach einem der vorhergehenden Ansprüche, **dadurch gekennzeichnet, dass** der Verbindungsbereich (11; 24) derart ausgebildet ist, dass bei Anordnung des Kontaktmittels (2; 22) zwischen dem Bedienfeld (16) und der gedruckten Schaltung (3) eine Berührung der gedruckten Schaltung (3) durch den Federabschnitt (7) vermieden wird.

8. Kontaktmittel nach Anspruch 7, **dadurch gekennzeichnet, dass** der Verbindungsbereich (11; 24) in einem Randbereich einer Projektionsfläche (26) des Federabschnitts (7) und des Anlageabschnitts (8) auf der gedruckten Schaltung (3) anliegt.

9. Kontaktmittel nach Anspruch 7, **dadurch gekennzeichnet, dass** der Verbindungsbereich (11; 24) in einander gegenüberliegenden Randbereichen einer Projektionsfläche (26) des Federabschnitts (7) und des Anlageabschnitts (8) auf die gedruckte Schaltung (3) auf einer Oberfläche der gedruckten Schaltung (3) anliegt.

10. Kontaktmittel nach Anspruch 8 oder 9, **dadurch gekennzeichnet, dass** der Verbindungsbereich (11; 24) für eine linienförmige und/oder für eine punktförmige Anlage auf der Oberfläche der gedruckten Schaltung (3) ausgebildet ist.

11. Bedieneinrichtung für ein Haushaltsgerät mit einem elektrisch isolierendem Bedienfeld (16) und einer Sensoreinrichtung (1) zur kapazitiven Abtastung des Bedienfelds (16), **gekennzeichnet durch** ein Kontaktmittel (2) nach einem der vorhergehenden Ansprüche, das zur Bereitstellung einer elektrisch leitenden Verbindung zwischen der Sensoreinrichtung (1) und dem Bedienfeld (16) eingerichtet ist.

12. Bedieneinrichtung nach Anspruch 11, **dadurch gekennzeichnet, dass** das Bedienfeld eine der Sensoreinrichtung (1) gegenüberliegende, zumindest im Wesentlichen ebene Anlagefläche für das Kontaktmittel (2) aufweist und dass das Bedienfeld (16) derart von der Sensoreinrichtung (1) beabstandet angeordnet ist, dass das Kontaktmittel (2) zumindest im Wesentlichen mit dem Anlageabschnitt (8) flächig an der Anlagefläche des Bedienfelds (16) anliegt.

13. Bedieneinrichtung nach Anspruch 11 oder 12, **dadurch gekennzeichnet, dass** die Sensoreinrichtung (1) eine gedruckte Schaltung (3) umfasst, an der das Kontaktmittel (2) angeordnet ist und dass auf einer Oberfläche der gedruckten Schaltung (3) elektrische Leiterbahnen (27) ausgebildet sind, die zumindest abschnittsweise über eine Projektionsfläche (26) des Federabschnitts (7) und des Anlageabschnitts (8) verlaufen und/oder elektrische Komponenten (4) angeordnet sind.

## Claims

1. Contact means made of an elongated spring-elastic material for coupling a control panel (16) made of an electrically insulating material to a sensor device (1; 21), the contact means comprising a mounting section (6; 23) for mounting on a printed circuit board (3), a spring section (7) for providing a contact force and a locating section (8) for location on the control panel (16), wherein the spring section (7) adjoins the mounting section (6; 23) and the locating section (8) adjoins the spring section (7) and the spring section (7) comprises at least one spring coil, wherein the locating section (8) is designed as a spiral spring and the coil radius (20a, 20b, 20c) of the spiral spring is reduced along the extent of the spiral spring as the distance from the spring section (7) increases, **characterised in that** a connecting region (11; 24), is formed in a tangential plane at the spring section (7) and has a V-shape in the tangential plane and connects the spring section (7) and the end region (10) of the mounting section (6; 23) to one another.

2. Contact means according to claim 1, **characterised in that** the change of the coil radius of the spiral spring within a spiral spring coil is at least equal to and in particular greater than the cross-section, in particular the diameter, of the elongated spring-elastic material.

3. Contact means according to claim 1 or 2, **characterised in that** a pitch (17) of the spring coil of the spring section (7) is chosen to be greater by at least 50%, preferably by at least 100%, than a pitch (19) of the spring coil of the spiral spring.

4. Contact means according to claim 1, 2 or 3, **characterised in that** a central axis (9) of the spiral spring is oriented at least substantially parallel to a central axis of the spring section (7), being preferably identical with the central axis of the spring coil.

5. Contact means according to any of the preceding claims, **characterised in that** the end region (10) of the mounting section (6), which is oriented at least substantially parallel to the central axis (9) of the spiral spring and/or the central axis (9) of the spring section, is designed for plugging into a recess in a printed circuit board (3), in particular of the sensor device (1; 21).

6. Contact means according to any of the preceding claims, **characterised in that** the spring section (7) is designed as a cylindrical helical spring.

7. Contact means according to any of the preceding claims, **characterised in that** the connecting region (11; 24) is designed such that, if the contact means (2; 22) is placed between the control panel (16) and the printed circuit board (3), a contact between the printed circuit board (3) and the spring section (7) is avoided.

8. Contact means according to claim 7, **characterised in that** the connecting region (11; 24) contacts the printed circuit board (3) in an edge region of a projection area (26) of the spring section (7) and of the locating section (8).

9. Contact means according to claim 7, **characterised in that** that the connecting region (11; 24) contacts a surface of the printed circuit board (3) in opposite end regions of a projection area (26) of the spring section (7) and of the locating section (8) on the printed circuit board (3).

10. Contact means according to claim 8 or 9, **characterised in that** the connecting region (11; 24) is designed for a linear and/or for a punctiform contact with the surface of the printed circuit board (3).

11. Control device for a domestic appliance, comprising an electrically insulating control panel (16) and a sensor device (1) for the capacitive scanning of the control panel (16), **characterised by** a contact means (2) according to any of the preceding claims, which is equipped to provide an electrically conductive connection between the sensor device (1) and the control panel (16).

12. Control device according to claim 11, **characterised in that** the control panel has a locating surface for the contact means (2), which locating surface is placed opposite the sensor device (1) and is at least substantially flat, and **in that** the control panel (16) is placed at such a distance from the sensor device (1) that the contact means (2) lies at least substantially flat on the locating surface of the control panel (16) with the locating section (8).

13. Control device according to claim 11 or 12, **characterised in that** the sensor device (1) comprises a printed circuit board (3), on which the contact means (2) is located, and **in that** electric conductors (27), which extend at least in some sections across a projection surface (26) of the spring section (7) and of the locating section (8), and/or electric components (4) are provided on a surface of the printed circuit board (3).

## Revendications

1. Moyen de contact composé d'un matériau élastique à ressort allongé servant au couplage d'un champ de commande (16) composé d'un matériau électriquement isolant avec un dispositif de détection (1 ; 21), lequel moyen de contact comprend un secteur de montage (6 ; 23) servant au montage sur un circuit imprimé (3), un secteur à ressort (7) servant à la fourniture d'une force de pression et un secteur d'appui (8) servant à l'appui sur le champ de commande (16), le secteur à ressort (7) étant contigu au secteur de montage (6 ; 23) et le secteur d'appui (8) étant contigu au secteur à ressort (7) et le secteur à ressort (7) comportant au moins un enroulement de ressort, le secteur d'appui (8) étant formé en tant que ressort à boudin et un rayon d'enroulement (20a, 20b, 20c) du ressort à boudin se réduisant le long de l'étendue du ressort à boudin plus il s'éloigne du secteur à ressort (7), **caractérisé en ce que** dans un plan tangentiel au secteur à ressort (7) est formée une zone de liaison (11 ; 24) qui présente, dans le plan tangentiel, un tracé en forme de V et qui relie entre eux le secteur à ressort (7) et la zone d'extrémité (10) du secteur de montage (6 ; 23).

2. Moyen de contact selon la revendication 1, **caractérisé en ce que** la variation du rayon d'enroulement du ressort à boudin à l'intérieur d'un enroulement de ressort à boudin est au moins égale, en particulier plus grande, que la section transversale, en particulier que le diamètre, du matériau élastique à ressort allongé.

3. Moyen de contact selon la revendication 1 ou 2, **caractérisé en ce qu'**un pas (17) de l'enroulement de ressort du secteur à ressort (7) est choisi au moins 50 %, de préférence au moins 100 %, plus grand qu'un pas (19) de l'enroulement de ressort du ressort à boudin.

4. Moyen de contact selon la revendication 1, 2 ou 3, **caractérisé en ce qu'**un axe médian (9) du ressort à boudin est orienté au moins essentiellement parallèle à un axe médian du secteur à ressort (7), de préférence de manière identique à l'axe médian de l'enroulement de ressort.

5. Moyen de contact selon l'une quelconque des revendications précédentes, **caractérisé en ce que** la zone d'extrémité (10) du secteur de montage (6) orientée au moins essentiellement parallèle à l'axe médian (9) du ressort à boudin et/ou de l'axe médian (9) du secteur à ressort est formée pour une insertion dans un logement dans un circuit imprimé (3), en particulier du dispositif de détection (1 ; 21).

6. Moyen de contact selon l'une quelconque des revendications précédentes, **caractérisé en ce que** le secteur à ressort (7) présente une forme de ressort spirale cylindrique.

7. Moyen de contact selon l'une quelconque des revendications précédentes, **caractérisé en ce que** la zone de liaison (11 ; 24) est formée de manière à empêcher, lors de la disposition du moyen de contact (2 ; 22) entre le champ de commande (16) et le circuit imprimé (3), un contact du circuit imprimé (3) par le secteur à ressort (7).

8. Moyen de contact selon la revendication 7, **caractérisé en ce que** la zone de liaison (11 ; 24) est située dans une zone d'extrémité d'une surface de projection (26) du secteur à ressort (7) et du secteur d'appui (8) sur le circuit imprimé (3).

9. Moyen de contact selon la revendication 7, **caractérisé en ce que** la zone de liaison (11 ; 24) est située sur une surface supérieure du circuit imprimé (3) dans des zones d'extrémité opposées d'une surface de projection (26) du secteur à ressort (7) et du secteur d'appui (8) sur le circuit imprimé (3).

10. Moyen de contact selon la revendication 8 ou 9, **caractérisé en ce que** la zone de liaison (11 ; 24) est formée pour un appui de forme linéaire et/ou pour un appui de forme ponctuelle sur la surface supérieure du circuit imprimé (3).

11. Dispositif de commande pour un appareil ménager avec un champ de commande (16) électriquement isolé et avec un dispositif de détection (1) pour le balayage capacitif du champ de commande (16), **caractérisé par** un moyen de contact (2) selon l'une quelconque des revendications précédentes qui est agencé pour la fourniture d'une liaison électroconductrice entre le dispositif de détection (1) et le champ de commande (16).

12. Dispositif de commande selon la revendication 11, **caractérisé en ce que** le champ de commande comprend une surface d'appui, opposée au dispositif de détection (1), au moins essentiellement plane, pour le moyen de contact (2) et **en ce que** le champ de commande (16) est disposé écarté du dispositif de détection (1) de sorte que le moyen de contact (2) repose contre la surface d'appui du champ de commande (16) d'une manière au moins essentiellement plane avec le secteur d'appui (8).

13. Dispositif de commande selon la revendication 11 ou 12, **caractérisé en ce que** le dispositif de détection (1) comprend un circuit imprimé (3) sur lequel est disposé le moyen de contact (2) et **en ce que** sur une surface supérieure du circuit imprimé (3) sont formées des pistes conductrices (27), qui sont réparties au moins par secteur sur une surface de projection (26) du secteur à ressort (7) et du secteur d'appui (8), et/ou des composants électriques (4).
